# EUROPEAN PATENT SPECIFICATION

(11) **EP 2 629 383 B1**
(45) Date of publication and mention of the grant of the patent: **02.04.2014**
(21) Application number: 12155878.7
(22) Date of filing: 17.02.2012
(51) Int. Cl.: H02B 1/56, H05K 7/20

(54) **Enclosure for housing electrical equipment**
Gehäuse zur Unterbringung eines elektrischen Geräts
Enceinte pour loger un équipement électrique

(43) Date of publication of application: 21.08.2013
(73) Proprietor: ABB Oy, 00380 Helsinki (FI)
(72) Inventor: Laurila, Risto, 00380 Helsinki (FI)
(74) Representative: Kolster Oy Ab

(56) References cited:
- WO-A1-99/53739
- US-A- 5 150 277
- US-A1- 2004 055 914

## Description

### FIELD OF THE INVENTION

The invention relates to an enclosure for housing electrical equipment.

### BACKGROUND OF THE INVENTION

Electrical equipment, such as electrical power equipment and/or electronic equipment, which is placed e.g. outdoors may need to be protected from adverse conditions. Such protection can be accomplished with a suitable enclosure around the electrical equipment. An example of an enclosure for electrical equipment is a container-type solution which can be easily transported.

The regulation of heat, including removal of waste heat from the electrical equipment, in such enclosures may be based on circulating air from outside the enclosure through the enclosure to cool down the electrical equipment in the enclosure. The air from outside the enclosure typically requires filtering, which may require, in turn, a large filter area or volume and/or cause a significant pressure loss to fans which circulate the air. The energy consumption of the fans may be significant thus deteriorating the overall efficiency of the equipment. In addition, replacement of the filters causes extra costs. The use of outside air may cause further problems because the outside air may contain moisture which may then condensate inside the enclosure and possibly cause corrosion or a short circuit. Further, if the outside air is too cold, it may pose a problem to heat regulation as some equipment may not be functional at low temperatures.

Another alternative for heat regulation in an enclosure for electrical equipment is to use various heat exchangers for transferring waste heat from the equipment inside the enclosure to the outside of the enclosure and thus to isolate the air inside the enclosure from the air outside the enclosure. Such heat exchangers may be bulky and require a lot of space inside the enclosure while available space may be limited.

Documents GB 2284659, WO 01/80615, WO 97/47167 and US 5467250 disclose solutions in which a heat exchanger has been mounted in a wall or door of the enclosure for electrical equipment. Such solutions may reduce the space required by the heat exchanger inside the enclosure. A possible problem with these solutions is that the heat regulating capacity of such a wall- or door-mounted heat exchanger may not be sufficient depending on the conditions inside and outside of the enclosure.

Document WO 99/53739 discloses a cabinet structure for housing electronic circuitry and electronic equipment. In the solution disclosed the electronic circuitry/equipment is surrounded by a body which includes profile elements. The profiles of the body structure include an inner wall, an outer wall, and an intermediate wall which extends between the outer wall and the inner wall and which constitutes a heat-exchanging surface. A first side of the heat-exchanging surface functions to cool air passing said surface, whereafter said cooled air is transported through the enclosed electronic circuitry and equipment.

### BRIEF DESCRIPTION OF THE INVENTION

An object of the invention is to provide an apparatus in such a way that the above problem can be solved or at least alleviated. The object of the invention is achieved with an enclosure for housing electrical equipment which is characterized by what is stated in the independent claim. Preferred embodiments of the invention are disclosed in the dependent claims.

The invention is based on the idea that, in addition to a wall part of an enclosure for housing electrical equipment comprising at least one first air channel connected to the interior chamber and the enclosure comprising at least one fan for circulating air from inside an interior chamber of the enclosure through the at least one first air channel, a bottom part of the enclosure for housing the electrical equipment comprises at least one second air channel connected to the interior chamber, and that the enclosure comprises at least one fan for circulating the air from inside the interior chamber through the at least one second air channel.

An advantage of the solution is that the heat regulation of the enclosure can be enhanced because the heat capacity of the bottom part of the enclosure and the soil can be utilized in reducing temperature variation inside the enclosure due to varying loss heat power. The solution is advantageous for example in connection with systems operating in cycles, such as solar power systems, in which the cycle of power dissipation naturally has a length of one day. This further facilitates the optimization of the equipment and the structures.

### BRIEF DESCRIPTION OF THE FIGURES

The invention will now be described in greater detail in connection with preferred embodiments, referring to the attached drawings, of which:
Figure 1 shows an enclosure according to an embodiment;
Figure 2 shows a part of a cross-section of the enclosure according to an embodiment; and
Figure 3 shows a cross section of a wall part of the enclosure according to an embodiment.

### DETAILED DESCRIPTION OF THE INVENTION

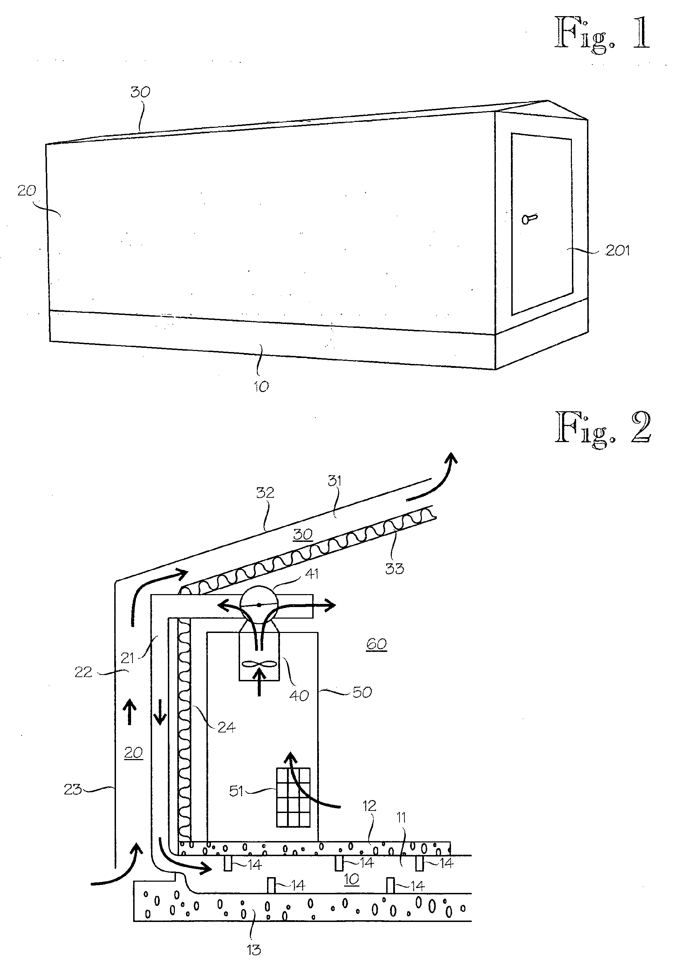

Figure 1 shows an enclosure according to an embodiment. It should be noted that the shape and size of the enclosure may vary. The enclosure may be used for housing electrical equipment, such as electrical power equipment and/or electronic equipment or other electrical equipment. The enclosure comprises a bottom part 10, a wall part 20 and a roof part 30. The bottom part 10, the wall part 20 and the roof 30 part define an interior chamber for housing the electrical equipment. The bottom part 10 may be made of e.g. concrete or some other material and can be of a single-piece or a multi-piece construction. The wall part 20 may comprise one or more wall elements, for example four wall elements as in Figure 1. At least one of the wall elements may comprise at least one door 201 providing access to the interior chamber and the equipment located there.

Figure 2 shows a part of a cross-section of the enclosure according to an embodiment. The wall part 20 comprises at least one first air channel 21 connected to the interior chamber 60 and the enclosure comprises at least one fan 40 for circulating air from inside the interior chamber 60 through the at least one first air channel 21. The at least one first air channel 21 may be located between an interior wall structure 24 and an exterior wall structure 23 within the wall part 20, for example. The interior wall structure 24 may be thermally insulated. The air circulated through the at least one first air channel 21 releases part of its heat energy through the wall structures to the air outside the enclosure and thus the air circulated through the at least one first air channel 21 cools down. The material of the at least one first air channel 21 is preferably heat conductive, such as aluminium, in order to ensure proper heat conduction. Moreover, the bottom part 10 comprises at least one second air channel 11 connected to the interior chamber 60, and the enclosure comprises at least one fan 40 for circulating the air from inside the interior chamber 60 through the at least one second air channel 11. The at least one second air channel 11 may be located between an inner floor structure 12 and a base floor structure 13, for example. The air circulated through the at least one second air channel 11 releases or receives heat energy to/from the floor structure. In addition, since the bottom part 10 typically lies against the soil when the enclosure has been assembled into use and heat exchange thus takes place between the bottom part 10 and the soil, also the heat capacity of the soil below the enclosure can be utilized. Typically, the temperature of the soil at a depth of approximately two meters settles around the yearly average temperature of the outside air and thus the soil can function as an effective heat sink.

In the example of Figure 1, the at least one first air channel 21 and the at least one second air channel 11 are connected in series and the same fan 40 is used to circulate air from inside the interior chamber 60 through the at least one first air channel 21 and also through the at least one second air channel 11. However, the at least one first air channel 21 and the at least one second air channel 11 need not be connected in series but may be separately connected to the interior chamber 60 and separate fans could be used for both said channels. The interior chamber 60, the at least one first air channel 21 and the at least one second air channel 11 are preferably substantially sealed from outside of the enclosure. In other words, the interior chamber 60, the at least one first air channel 21 and the at least one second air channel 11 form a substantially closed environment inside the enclosure.

As shown in the example of Figure 2, the enclosure comprises at least one cabinet 50 for electrical equipment inside the interior chamber 60, wherein the at least one first air channel 21 is connected to the at least one cabinet 50 such that the air circulated from inside the interior chamber 60 through the at least one first air channel 21 enters the at least one first air channel 21 through the at least one cabinet 50. The at least one cabinet 50 may have suitable openings 51 for enabling the flow of air through it. This enhances the cooling of the equipment inside the cabinet 50. Moreover, the point of connection between the at least one first air channel 21 and the at least one cabinet 50 comprises a first regulating element 41 for adjusting an amount of air transferred from the at least one cabinet 50 to the at least one first air channel 21 and for adjusting an amount of air circulated through the at least one cabinet 50 within the interior chamber 60. The first regulating element 41 may be combined with the fan 40, or they may be separate elements. The first regulating element 41 thus adjusts which portion of air circulated through the at least one cabinet 50, on one hand, enters the at least one first air channel 21 and which portion of air circulated through the at least one cabinet 50, on the other hand, exits the at least one cabinet 50 yet stays within the interior chamber 60. The flow of air has been shown with arrows in the figure. Thus the first regulating element 41 may be used for adjusting the temperature inside the enclosure.

In case the at least one first air channel 21 and the at least one second air channel 11 are connected in series as in the example of Figure 2, the point of connection between the at least one first air channel 21 and the at least one second air channel 11 may comprise a second regulating element (not shown in the figure) for adjusting an amount of air transferred between the at least one first air channel 21 and the at least one second air channel 11 and for adjusting an amount of air released back to the interior chamber 60 from said connection point. This way the flow of air through the at least one first air channel 21 and the one through the at least one second air channel 11 could be adjusted individually.

According to an embodiment, the wall part 20 may comprise at least one third air channel 22 connected to the outside of the enclosure, in which case the at least one first air channel 21 and the at least one third air channel 22 may form a heat exchanger. The at least one first air channel 21 and the at least one third air channel 22 preferably run side by side inside the wall part 20 to ensure proper heat exchange between them. The air is preferably circulated generally downwards inside the at least one first air channel 21 and generally upwards inside the at least one third air channel 22. The enclosure may comprise at least one fan (not shown in the figures) for circulating air from outside of the enclosure through the at least one third air channel 22. Such a fan may be located at either end of the air channel, for example. Alternatively, the air from the outside of the enclosure may circulate through the at least one third air channel 22 by natural convection caused by the fact that warm air tends to move upwards. This natural convection may be enhanced by continuing the at least one third air channel 22 with at least one fourth air channel 31 through the roof part 30, thus utilizing the air flow warming effect of the sun shining to the roof 30. Within the roof part 30 the at least one fourth air channel 31 may be located between an interior roof structure 33 and an exterior roof structure 32, for example. The interior roof structure 33 may be thermally insulated. The natural air flow through the at least one third air channel 22 and/or at least one fourth air channel 31 may be further enhanced by using suitable materials or coatings e.g. as follows:
1) The emissivity of an exterior surface of the exterior wall structure 23 against direct radiation from the sun should preferably be as low as possible, i.e. generally low against heat radiation from the outside of the enclosure. The emissivity of the exterior wall structure 23 against low temperature radiation between surfaces should preferably also be as low as possible. This allows the heating effect of direct radiation from the sun to the wall structure to be minimized. On the other hand, the interior wall structures should preferably have high low-temperature emissivities as heat exchange in the interior wall structures is desired.
2) In the roof structure the heating effect of the sun on the air flow channel 31 is desirable and thus an exterior surface of the exterior roof structure 32 should preferably have a high high-temperature emissivity, i.e. a high emissivity against heat radiation from the outside of the enclosure, but preferably a low low-temperature emissivity and the inside surfaces of the channel 31 should preferably have high low-temperature emissivities.

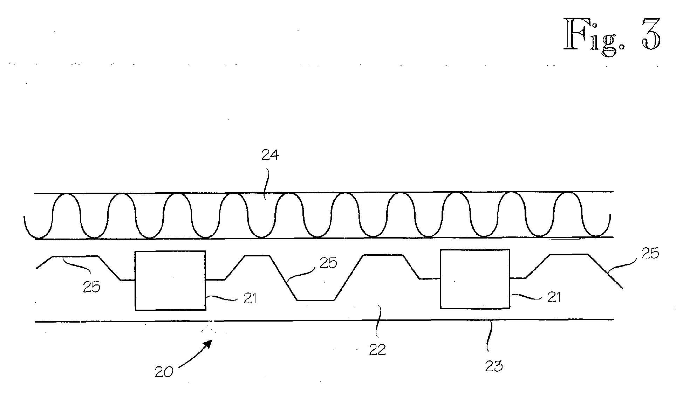

Figure 3 shows a cross section of the wall part 20 of the enclosure according to an embodiment. According to an embodiment, the wall part comprises at least one rib 25 attached to the at least one first air channel 21, the rib extending to the at least one third air channel 22. The purpose of the at least one rib 25 is to enhance heat exchange between the at least one first air channel 21 and the at least one third air channel 22. The at least one rib 25 may be straight or corrugated, as shown in the figure, to enlarge the heat exchanging surface area and thus further enhance heat exchange between the air flowing inside the at least one first air channel 21 and the air flowing inside the at least one third air channel 22. The material of the at least one rib 25 is preferably heat conductive, such as aluminium, in order to ensure proper heat conduction.

According to an embodiment, the bottom part 10 comprises at least one rib 14 extending inside the at least one second air channel 11. Such ribs 14 may be used to further enhance heat exchange between the air circulated through the at least one second air channel 11 and the floor structure. The one or more ribs 14 extending inside the at least one second air channel 11 may be integral parts of the bottom part 10 or separate parts attached to e.g. the inner floor structure 12 and the base floor structure 13. The shape and size of the at least one rib 14 extending inside the at least one second air channel 11 may vary from that shown in the example of Figure 2.

The air flow through the at least one first air channel 21 and the at least one second air channel 11 may be controlled according to at least one of the following: temperature inside the enclosure, temperature outside the enclosure, time of day, temperature of the bottom part 10. Also other parameters may be used. As an example, the control of the air flow may be implemented such that the thermal energy stored in the bottom part 10 is maximized. Generally the bottom part 10 of the enclosure may be used to even out the daily variation of temperature inside the enclosure caused by the dissipation power of the electrical equipment, on one hand, by storing thermal energy from the air flow inside the at least one second air channel 11 to the bottom part 10 and, on the other hand, by releasing thermal energy from the bottom part 10 to the air flow inside the at least one second air channel 11. A bottom part made of e.g. concrete or a similar material may store the thermal power peak occurring around noon and the stored thermal energy may then be transferred to the outside air during night-time. The control according to the various embodiments described above may be implemented by controlling the operation of the fan(s) 40 and the regulating element(s) 41. The operation of the fan(s) 40 and the regulating element(s) 41 may be controlled by one or more control units (not shown separately in the figures), which may be integrated into the fan(s) 40 and the regulating element(s) 41 or they may be separate elements within the enclosure or possibly at a remote location. Such a control unit may be implemented by means of a computer or corresponding digital signal processing equipment provided with suitable software, for example. The control unit preferably comprises also suitable input means for receiving e.g. measurement and/or control data and output means for outputting control data.

It will be obvious to a person skilled in the art that as the technology advances, the basic idea of the invention may be implemented in a plurality of ways. The invention and its embodiments are thus not restricted to the examples described above but may vary within the scope of the claims.

## Claims

1. An enclosure for housing electrical equipment, the enclosure comprising:
a bottom part (10);
a wall part (20); and
a roof part (30); wherein
the bottom part (10), the wall part (20) and the roof part (30) define an interior chamber (60) for housing the electrical equipment;
the wall part (20) comprises at least one first air channel (21) connected to the interior chamber (60);
the bottom part (10) comprises at least one second air channel (11) connected to the interior chamber (60);
the enclosure comprises at least one fan (40) for circulating air from inside the interior chamber (60) through the at least one first air channel (21); and
the enclosure comprises at least one fan (40) for circulating the air from inside the interior chamber (60) through the at least one second air channel (11), **characterized in that**
the enclosure comprises, inside the interior chamber (60), at least one cabinet (50) for the electrical equipment, wherein the at least one first air channel (21) is connected to the at least one cabinet such that the air circulated from inside the interior chamber through the at least one first air channel (21) enters the at least one first air channel through the at least one cabinet, and **in that**
the connection point of the at least one first air channel (21) and the at least one cabinet (50) comprises a first regulating element (41) for adjusting an amount of air transferred from the at least one cabinet to the at least one first air channel and for adjusting an amount of air circulated through the at least one cabinet within the interior chamber (60)

2. An enclosure according to claim 1, **characterized in that** the interior chamber (60), the at least one first air channel (21) and the at least one second air channel (11) are substantially sealed from the outside of the enclosure.

3. An enclosure according to claim 1 or 2, **characterized in that** the at least one first air channel (21) and the at least one second air channel (11) are connected in series.

4. An enclosure according to claim 3, **characterized in that** the connection point of the at least one first air channel (21) and the at least one second air channel (11) comprises a second regulating element for adjusting an amount of air transferred between the at least one first air channel (21) and the at least one second air channel (11) and for adjusting an amount of air released back to the interior chamber (60) from said connection point.

5. An enclosure according to any one of claims 1 to 4, **characterized in that** the wall part (20) comprises at least one third air channel (22) connected to the outside of the enclosure, wherein the at least one first air channel (21) and the at least one third air channel (22) form a heat exchanger.

6. An enclosure according to claim 5, **characterized in that** an emissivity of an exterior surface of an exterior wall part structure (23) against heat radiation from the outside of the enclosure is low.

7. An enclosure according to claim 5 or 6, **characterized in that** the roof part (30) comprises at least one fourth air channel (31) connected to the at least one third air channel (22).

8. An enclosure according to claim 7, **characterized in that** an emissivity of an exterior surface of an exterior roof part structure (32) against heat radiation from the outside of the enclosure is high.

9. An enclosure according to any one of claims 5 to 8, **characterized in that** the enclosure comprises at least one fan for circulating air from the outside of the enclosure through the at least one third air channel.

10. An enclosure according to any one of claims 1 to 9, **characterized in that** the wall (20) part comprises at least one rib 25) attached to the at least one first air channel (21), which rib extends to the at least one third air channel (22).

11. An enclosure according to any one of claims 1 to 10, **characterized in that** the bottom part (10) comprises at least one rib (14) extending inside the at least one second air channel (11).

12. An enclosure according to any one of claims 1 to 11, **characterized in that** the wall part (20) comprises one or more wall elements.

13. An enclosure according to claim 12, **characterized in that** at least one of the one or more wall elements comprises a door (201).

## Patentansprüche

1. Gehäuse zur Unterbringung von elektrischen Vorrichtungen, welches Gehäuse aufweist:
einen Bodenteil (10);
einen Wandteil (20); und
einen Dachteil (30); worin
der Bodenteil (10), der Wandteil (20) und der Dachteil (30) eine innere Kammer (60) zur Unterbringung der elektrischen Vorrichtungen definieren;
der Wandteil (20) zumindest einen ersten Luftkanal (21) aufweist, der mit der inneren Kammer (60) verbunden ist;
der Bodenteil (10) zumindest einen zweiten Luftkanal (11) aufweist, der mit der inneren Kammer (60) verbunden ist;
das Gehäuse zumindest ein Gebläse (40) zur Umwälzung von Luft von innerhalb der inneren Kammer (60) durch den zumindest einen ersten Luftkanal (21) aufweist; und
das Gehäuse zumindest ein Gebläse (40) zur Umwälzung der Luft von innerhalb der inneren Kammer (60) durch den zumindest einen zweiten Luftkanal (11) aufweist; **dadurch gekennzeichnet, dass**
das Gehäuse innerhalb der inneren Kammer (60) zumindest eine Kabine (50) für die elektrischen Vorrichtungen aufweist, wobei der zumindest eine erste Luftkanal (21) mit der zumindest einen Kabine derart verbunden ist, dass die von innerhalb der inneren Kammer durch den zumindest einen ersten Luftkanal (21) umgewälzte Luft in den zumindest einen ersten Luftkanal durch die zumindest eine Kabine eindringt, und dass
der Verbindungspunkt des zumindest einen ersten Luftkanals (21) und der zumindest einen Kabine (50) ein erstes Regulierelement (41) zur Einstellung einer von der zumindest einen Kabine in den zumindest einen ersten Luftkanal übertragenen Luftmenge und zur Einstellung einer durch die zumindest eine Kabine innerhalb der inneren Kammer (60) umgewälzten Luftmenge aufweist.

2. Gehäuse nach Patentanspruch 1, **dadurch gekennzeichnet, dass** die innere Kammer (60), der zumindest eine erste Luftkanal (21) und der zumindest eine zweite Luftkanal (11) wesentlich von außerhalb des Gehäuses abgedichtet sind.

3. Gehäuse nach Patentanspruch 1 oder 2, **dadurch gekennzeichnet, dass** der zumindest eine erste Luftkanal (21) und der zumindest eine zweite Luftkanal (11) in Serie geschaltet sind.

4. Gehäuse nach Patentanspruch 3, **dadurch gekennzeichnet, dass** der Verbindungspunkt des zumindest einen ersten Luftkanals (21) und des zumindest einen zweiten Luftkanals (11) ein zweites Regulierelement zur Einstellung einer zwischen dem zumindest einen ersten Luftkanal (21) und dem zumindest einen zweiten Luftkanal (11) übertragenen Luftmenge und zur Einstellung einer vom besagten Verbindungspunkt zurück in die innere Kammer (60) eingelassenen Luftmenge aufweist.

5. Gehäuse nach einem der Patentansprüche 1 bis 4, **dadurch gekennzeichnet, dass** der Wandteil (20) zumindest einen dritten Luftkanal (22) aufweist, der mit der Außenseite des Gehäuses verbunden ist, wobei der zumindest eine erste Luftkanal (21) und der zumindest eine dritte Luftkanal (22) einen Wärmetauscher ausbilden.

6. Gehäuse nach Patentanspruch 5, **dadurch gekennzeichnet, dass** der Emissionsgrad einer Außenfläche einer äußeren Wandteilstruktur (23) gegenüber der Wärmestrahlung von außerhalb des Gehäuses gering ist.

7. Gehäuse nach Patentanspruch 5 oder 6, **dadurch gekennzeichnet, dass** der Dachteil (30) zumindest einen vierten Luftkanal (31) aufweist, der mit dem zumindest einen dritten Luftkanal (22) verbunden ist.

8. Gehäuse nach Patentanspruch 7, **dadurch gekennzeichnet, dass** der Emissionsgrad einer Außenfläche einer äußeren Dachteilstruktur (32) gegenüber der Wärmestrahlung von außerhalb des Gehäuses hoch ist.

9. Gehäuse nach einem der Patentansprüche 5 bis 8, **dadurch gekennzeichnet, dass** das Gehäuse zumindest ein Gebläse zur Umwälzung von Luft von außerhalb des Gehäuses durch den zumindest einen dritten Luftkanal aufweist.

10. Gehäuse nach einem der Patentansprüche 1 bis 9, **dadurch gekennzeichnet, dass** der Wandteil (20) zumindest eine Rippe (25) aufweist, die am zumindest einen ersten Luftkanal (21) befestigt ist, welche Rippe sich bis zum zumindest einen dritten Luftkanal (22) erstreckt.

11. Gehäuse nach einem der Patentansprüche 1 bis 10, **dadurch gekennzeichnet, dass** der Bodenteil (10) zumindest eine Rippe (14) aufweist, die sich innerhalb des zumindest einen zweiten Luftkanals (11) erstreckt.

12. Gehäuse nach einem der Patentansprüche 1 bis 11, **dadurch gekennzeichnet, dass** der Wandteil (20) ein oder mehr Wandelemente aufweist.

13. Gehäuse nach Patentanspruch 12, **dadurch gekennzeichnet, dass** zumindest eines der einen oder mehr Wandelemente eine Tür (201) aufweist.

## Revendications

1. Enceinte pour loger un équipement électrique, l'enceinte comprenant :
une partie formant fond (10) ;
une partie formant paroi (20) ; et
une partie formant toit (30) ; dans laquelle
la partie formant fond (10), la partie formant paroi (20) et la partie formant toit (30) définissent une chambre intérieure (60) pour loger l'équipement électrique ;
la partie formant paroi (20) comprend au moins un premier canal d'aération (21) raccordé à la chambre intérieure (60) ;
la partie formant fond (10) comprend au moins un deuxième canal d'aération (11) raccordé à la chambre intérieure (60) ;
l'enceinte comprend au moins un ventilateur (40) pour faire circuler l'air provenant de l'intérieur de la chambre intérieure (60) à travers l'au moins un premier canal d'aération (21) ; et
l'enceinte comprend au moins un ventilateur (40) pour faire circuler l'air provenant de l'intérieur de la chambre intérieure (60) à travers l'au moins un deuxième canal d'aération (11), **caractérisée en ce que**
l'enceinte comprend, à l'intérieur de la chambre intérieure (60), au moins une armoire (50) pour l'équipement électrique, dans laquelle l'au moins un premier canal d'aération (21) est raccordé à l'au moins une armoire de telle sorte que l'air circulant depuis l'intérieur de la chambre intérieure à travers l'au moins un premier canal d'aération (21) pénètre dans l'au moins un premier canal d'aération à travers l'au moins une armoire, et **en ce que**
le point de raccordement de l'au moins un premier canal d'aération (21) et de l'au moins une armoire (60) comprend un premier élément régulateur (41) pour ajuster une quantité d'air transférée de l'au moins une armoire vers l'au moins un premier canal d'aération et pour ajuster une quantité d'air circulant à travers l'au moins une armoire à l'intérieur de la chambre intérieure (60).

2. Enceinte selon la revendication 1, **caractérisée en ce que** la chambre intérieure (60), l'au moins un premier canal d'aération (21) et l'au moins un deuxième canal d'aération (11) sont sensiblement scellés par rapport à l'extérieur de l'enceinte.

3. Enceinte selon la revendication 1 ou 2, **caractérisée en ce que** l'au moins un premier canal d'aération (21) et l'au moins un deuxième canal d'aération (11) sont raccordés en série.

4. Enceinte selon la revendication 3, **caractérisée en ce que** le point de raccordement de l'au moins un premier canal d'aération (21) et de l'au moins un deuxième canal d'aération (11) comprend un second élément régulateur pour ajuster une quantité d'air transférée entre l'au moins un premier canal d'aération (21) et l'au moins un deuxième canal d'aération (11) et pour ajuster une quantité d'air libérée à nouveau vers la chambre intérieure (60) depuis ledit point de raccordement.

5. Enceinte selon l'une quelconque des revendications 1 à 4, **caractérisée en ce que** la partie formant paroi (20) comprend au moins un troisième canal d'aération (22) raccordé à l'extérieur de l'enceinte, dans laquelle l'au moins un premier canal d'aération (21) et l'au moins un troisième canal d'aération (22) forment un échangeur thermique.

6. Enceinte selon la revendication 5, **caractérisée en ce qu'**une émissivité d'une surface extérieure d'une structure de partie formant paroi extérieure (23) par rapport au rayonnement thermique provenant de l'extérieur de l'enceinte est faible.

7. Enceinte selon la revendication 5 ou 6, **caractérisée en ce que** la partie formant toit (30) comprend au moins un quatrième canal d'aération (31) raccordé à l'au moins un troisième canal d'aération (22).

8. Enceinte selon la revendication 7, **caractérisée en ce qu'**une émissivité d'une surface extérieure d'une structure de partie formant toit extérieure (32) par rapport au rayonnement thermique provenant de l'extérieur de l'enceinte est élevée.

9. Enceinte selon l'une quelconque des revendications 5 à 8, **caractérisée en ce que** l'enceinte comprend au moins un ventilateur pour faire circuler l'air depuis l'extérieur de l'enceinte à travers l'au moins un troisième canal d'aération.

10. Enceinte selon l'une quelconque des revendications 1 à 9, **caractérisée en ce que** la partie formant paroi (20) comprend au moins une nervure (25) fixée à l'au moins un premier canal d'aération (21), laquelle nervure s'étend vers l'au moins un troisième canal d' aération (22).

11. Enceinte selon l'une quelconque des revendications 1 à 10, **caractérisée en ce que** la partie formant fond (10) comprend au moins une nervure (14) s'étendant à l'intérieur de l'au moins un deuxième canal d' aération (11).

12. Enceinte selon l'une quelconque des revendications 1 à 11, **caractérisée en ce que** la partie formant paroi (20) comprend un ou plusieurs éléments formant paroi.

13. Enceinte selon la revendication 12, **caractérisée en ce qu'**au moins un de l'un ou plusieurs éléments formant paroi comprend une porte (201).
